# EUROPÄISCHE PATENTSCHRIFT

(11) **EP 0 981 756 B1**
(45) Veröffentlichungstag und Bekanntmachung des Hinweises auf die Patenterteilung: **16.01.2002**
(21) Anmeldenummer: 98933434.7
(22) Anmeldetag: 04.05.1998
(51) Int. Cl.: G01R 15/24

(54) **GENERATOR UND VERFAHREN ZUR MESSUNG EINER GENERATORSPANNUNG**
GENERATOR FOR AND METHOD OF MEASURING A VOLTAGE OF THE GENERATOR
GENERATEUR ET METHODE DE MESURE D'UNE TENSION DE GENERATEUR

(30) Priorität: 13.05.1997 DE 19719970
(43) Veröffentlichungstag der Anmeldung: 01.03.2000
(73) Patentinhaber: SIEMENS AKTIENGESELLSCHAFT, 80333 München (DE)
(72) Erfinder: KLAAR, Jürgen, D-47506 Neukirchen-Vluyn (DE)
(86) Internationale Anmeldenummer: DE9801219
(87) Internationale Veröffentlichungsnummer: WO9852055

(56) Entgegenhaltungen:
- WO-A-93/12435
- WO-A-97/18477
- US-A- 4 269 483
- US-A- 5 136 236

## Beschreibung

Die Erfindung betrifft einen Generator und ein Verfahren zur Messung einer Generatorspannung.

In dem Artikel "Faseroptische Sensoren", Teil 3: Faseroptische Spannungsmessung, von Klaus Bohnert, Bulletin SPV/VSE 82 (1991),Seite 27-32, ist beschrieben, wie eine Spannungsmessung unter Ausnutzung verschiedener optischer Effekte erfolgen kann. Die Effekte sind im einzelnen:
1. Linearer elektrooptischer Effekt (Pockels-Effekt). Der Pockels-Effekt tritt in Materialien mit nicht zentrosymmetrischer Kristallstruktur auf. Ein äußeres elektrisches Feld kann in einem solchen Material eine optische Doppelbrechung hervorrufen. Tritt zirkular polarisiertes Licht in ein solches doppelbrechendes Material ein, so wird es im allgemeinen in elliptisch polarisiertes Licht umgewandelt. Mit Hilfe eines Analysators kann diese Umwandlung als Lichtintensitätsänderung in einem Empfänger gemessen und damit das angelegte äußere elektrische Feld bestimmt werden.
2. Quadratischer elektrooptischer Effekt (Kerr-Effekt). In Materialien mit einer Zentrosymmetrie sowie in amorphen Strukturen (z.B. Gläser) kann sich der Brechungsindex quadratisch mit der Stärke eines äußeren elektrischen Feldes ändern. Dieser Kerr-Effekt führt ebenfalls zu einer Doppelbrechung des Materials. Das elektrische Feld wird meßtechnisch analog zum Pockels-Effekt bestimmt.
3. Piezo-Effekt. Ein piezoelektrisches Material erfährt unter der Einwirkung eines äußeren elektrischen Feldes eine Längenänderung. Indem z.B. ein Lichtwellenleiter auf einen als Zylinder ausgeführten piezoelektrischen Kristall, z.B. Quarz, gewickelt wird, kann eine durch ein elektrisches Feld über den Piezoeffekt hervorgerufene Änderung des Umfangs des Zylinders durch die Änderung der optischen Weglänge in der lichtleitenden Faser bestimmt werden. Eine solche Längenänderung kann interferometrisch sehr empfindlich bestimmt werden. Aus dieser Längenänderung wird auf das elektrische Feld zurückgeschlossen.

In dem genannten Artikel wird ausgeführt, wie mit Hilfe eines piezoelektrischen Spannungssensors eine Hochspannung gemessen werden kann. Es ist eine aus mehreren hintereinander geschalteten Quarzscheiben aufgebaute Sensorvorrichtung beschrieben, die es insbesondere bei wechselnden Umweltbedingungen (z.B. Feuchtigkeit und Temperatur) gestattet, durch Messung des elektrischen Feldes, basierend auf dem Piezoeffekt wie oben beschrieben, eine Hochspannung zu bestimmen.

In dem Buch "Monitoring and Diagnosis of Turbine Driven Generators" von A. Gonzales, M.S. Baldwin und J. Stein, Prentice Hall, Englewood Cliffs/New Jersey, 1995 ist beschrieben, daß es bei dem Betrieb eines Generators, insbesondere eines turbinengetriebenen Generators (nachfolgend als Turbogenerator bezeichnet) großer Leistung, erforderlich ist, Meßgrößen zu erfassen, um den Betriebszustand des Generators zu kontrollieren. Eine solche Meßgröße kann eine im oder am Generator auftretende Generatorspannung sein.

Die US-PS 4,994,684 betrifft eine Vorrichtung und ein Verfahren zur Steuerung der Energieumwandlung von Rotationsenergie in elektrische Energie bei einer variablen Rotationsgeschwindigkeit. Unter anderem ist ein Spannungssensor vorgesehen, der eine von der Statorwicklung hervorgerufene Generatorspannung mißt. Über die konkrete Ausführungsform dieses Spannungssensors schweigt die D1.

Die US-PS 5,136,236 betrifft eine gasisolierte Schaltanlage. Die Spannung zwischen einem zylindrischen Leiter und einem diesen umgebenden, ebenfalls zylindrischen Schutzgehäuse wird über piezoelektrische Sensoren gemessen. Auf jedem piezoelektrischen Sensor ist eine Glasfaser aufgewickelt. Die Spannung wird durch die Einwirkung des elektrischen Feldes auf die piezoelektrischen Sensoren gemessen, die je nach Stärke des elektrischen Feldes aufgrund einer entsprechenden Längenausdehnung eine entsprechende optische Weglänge für die aufgewickelte Glasfaser zur Folge haben.

Aufgabe der Erfindung ist es, einen Generator anzugeben, bei dem die Messung einer Generatorspannung in einfacher Weise möglich ist. Weitere Aufgabe der Erfindung ist die Angabe eines Verfahrens zur Messung einer Generatorspannung.

Erfindungsgemäß wird die auf einen Generator gerichtete Aufgabe gelöst durch Angabe eines Generators mit einer elektrischen Wicklung und einer, mit der elektrischen Wicklung verbundenen, elektrischen Ableitung, wobei eine optische Meßvorrichtung zur Messung einer von der elektrischen Wicklung hervorrufbaren Generatorspannung vorgesehen ist, umfassend:
a) ein Sensorelement mit einer optischen Eigenschaft, durch welche ein auf das Sensorelement wirkendes, von der Generatorspannung hervorgerufenes elektrisches Feld bestimmbar ist und
b) eine mit dem Sensorelement verbundene, lichtleitfähige Faser.

Ein solcher Generator gestattet es, eine im oder am Generator auftretende elektrische Generatorspannung mittels einer optischen Spannungsmessung zu bestimmen. Eine solche Generatorspannung kann z. B. an einem Rotor, an einem Stator oder an einer Erregermaschine des Generators auftreten. Eine Vorrichtung zur optischen Spannungsmessung ist robust, hochspannungsfest, einfach und kostengünstig ausführbar. Insbesondere die bei einem Turbogenerator in der Regel auftretenden hohen Spannungen erfordern bisher eine aufwendige und teure Spannungsmessung. Gerade für die spezifischen, technischen Bedingungen eines solchen Generators erweist sich eine Spannungsmessung über ein elektrisches Feld unter Ausnutzung optischer Effekte als besonders geeignet.

Bevorzugt ist das Sensorelement ein Teil der lichtleitfähigen Faser. Damit ist es nicht nötig, zur Messung des elektrischen Feldes ein eigenes Bauteil vorzusehen, da über die optischen Eigenschaften der lichtleitfähigen Faser selbst die Bestimmung der Generatorspannung erfolgen kann.

Bevorzugt ist die optische Eigenschaft eine Doppelbrechung, welche über den, als Pockels-Effekt bezeichneten, linearen elektrooptischen Effekt durch das elektrische Feld hervorrufbar ist. Weiter bevorzugt ist die optische Eigenschaft eine Doppelbrechung, welche über den, als Kerr-Effekt bezeichneten, quadratischen elektrooptischen Effekt durch das elektrische Feld hervorrufbar ist.

Sowohl bei der Messung mittels des Pockels-Effektes als auch mittels des Kerr-Effektes wird dem Sensorelement über die lichtleitfähige Faser ein Lichtstrahl zugeführt. Eine Eigenschaft dieses Lichtstrahls, insbesondere die Drehung seiner Polarisationsebene im Falle eines linear polarisierten Lichtstrahls oder der Phasenverschiebung der Linearkomponenten eines zirkular polarisierten Lichtstrahls, wird durch das Sensorelement über das elektrische Feld verändert, wie oben ausgeführt wurde. Der so veränderte Lichtstrahl wird von dem Sensorelement wiederum durch eine lichtleitfähige Faser einer Auswerteeinheit zugeführt. In der Auswerteeinheit erfolgt die Bestimmung des elektrischen Feldes über die Änderung der Eigenschaft des Lichtstrahls. Aus dem elektrischen Feld wird die zu messende Spannung bestimmt.

Weiter bevorzugt ist die optische Eigenschaft die energetische Lage oder die Aufspaltung einer Spektrallinie, die über den Stark-Effekt durch das elektrische Feld änderbar bzw. hervorrufbar ist. Bei dem Stark-Effekt wird ein atomares oder molekulares Energieniveau durch ein elektrisches Feld aufgespalten oder verschoben. Ein durch ein den Stark-Effekt zeigendes. Sensorelement geleiteter, geeigneter Lichtstrahl verändert damit mindestens eine seiner spektralen Eigenschaften, insbesondere seine Intensität durch eine erhöhte oder verringerte Absorption im Sensorelement. Über diese Veränderung läßt sich das elektrische Feld und daraus die Generatorspannung bestimmen.

Weiter bevorzugt ist die optische Eigenschaft der optischen Weglänge eines Lichtstrahles durch das Sensorelement, welche über den Piezo-Effekt durch das elektrische Feld änderbar ist. Das Sensorelement ist hier vorzugsweise aus einem piezoelektrischen Bauteil und einer an diesem Bauteil angeordneten lichtleitfähigen Faser aufgebaut. Die zum Sensorelement gehörige, lichtleitfähige Faser ist dabei so mit dem piezoelektrischen Bauelement verbunden, daß sich ihre Länge aufgrund des im piezoelektrischen Bauteil wirkenden Piezo-Effektes ändert. Ein äußeres elektrisches Feld führt somit zur Änderung der optischen Weglänge durch das Sensorelement. Aus der optischen Weglänge läßt sich auf das elektrische Feld schließen und daraus die Generatorspannung bestimmen.

Weiter bevorzugt ist das Sensorelement an der Ableitung angeordnet. Bevorzugtermaßen ist die Ableitung von einem Hüllrohr umgeben, wobei das Sensorelement an oder in diesem Hüllrohr angeordnet ist. Zwischen der Ableitung und dem sie umgebenden Hüllrohr liegt ein elektrisches Feld. Durch eine einfache Geometrie an dieser Meßstelle ergibt sich ein räumlich konstantes elektrisches Feld. Damit liegt hier eine besonders günstige Position zur Spannungsmessung mittels einer optischen Meßvorrichtung vor, da die indirekte Spannungsmessung über ein elektrisches Feld dann besonders gut und reproduzierbar ausführbar ist, wenn das elektrische Feld im Bereich des Sensorelements räumlich konstant ist.

Bevorzugtermaßen weist die Ableitung einen Schalter auf, über den eine Stromführung in der Ableitung ein- und abschaltbar ist, wobei die Meßvorrichtung an oder in diesem Schalter angeordnet ist. Weiter bevorzugt führt die Ableitung mittels einer Stromdurchführung aus dem Generatorgehäuse, wobei das Sensorelement an oder in der Stromdurchführung angeordnet ist.

Bevorzugt ist eine optische Strommeßvorrichtung vorgesehen, welche mit der Meßvorrichtung zu einer optischen Leistungsmessung kombinierbar ist. Eine solche optische Strommeßvorrichtung ist in dem Artikel "Faseroptische Sensoren, Teil 2: Faseroptische Stromsensoren" von Roland Stierlin, Bulletin SEV/VSE 82(1991), Seite 21-29 beschrieben, worauf hier explizit Bezug genommen wird.

Weiter bevorzugt ist der Generator als Turbogenerator ausgeführt, insbesondere mit einer Leistung größer als 10 MVA.

Erfindungsgemäß wird die auf ein Verfahren gerichtete Aufgabe gelöst durch Angabe eines Verfahrens zur Messung einer Generatorspannung eines Generators, umfassend eine elektrische Wicklung mit der eine elektrischen Ableitung verbunden ist, wobei die Generatorspannung über ein elektrisches Feld auf ein Sensorelement wirkt, welches Sensorelement unter dieser Wirkung eine optische Eigenschaft annimmt und wobei ein Lichtstrahl über eine lichtleitende Faser dem Sensorelement zugeführt, ein geänderter Lichtstrahl vom Sensorelement abgestrahlt und aus diesem geänderten Lichtstrahl die optische Eigenschaft des Sensorelementes und daraus die Generatorspannung ermittelt wird.

Die Vorteile dieses Verfahrens ergeben sich entsprechend den obigen Ausführungen zu einem Generator.

Ein Ausführungsbeispiel der Erfindung wird anhand der Zeichnung näher erläutert. Es zeigen:
- FIG 1: eine schematische Darstellung des Meßprinzips,
- FIG 2: einen Generator mit eingebauter optischer Meßvorrichtung und
- FIG 3: einen Teil einer aus dem Generator führenden Ableitung.

Gleiche Bezugszeichen haben in den verschiedenen Figuren die gleiche Bedeutung.

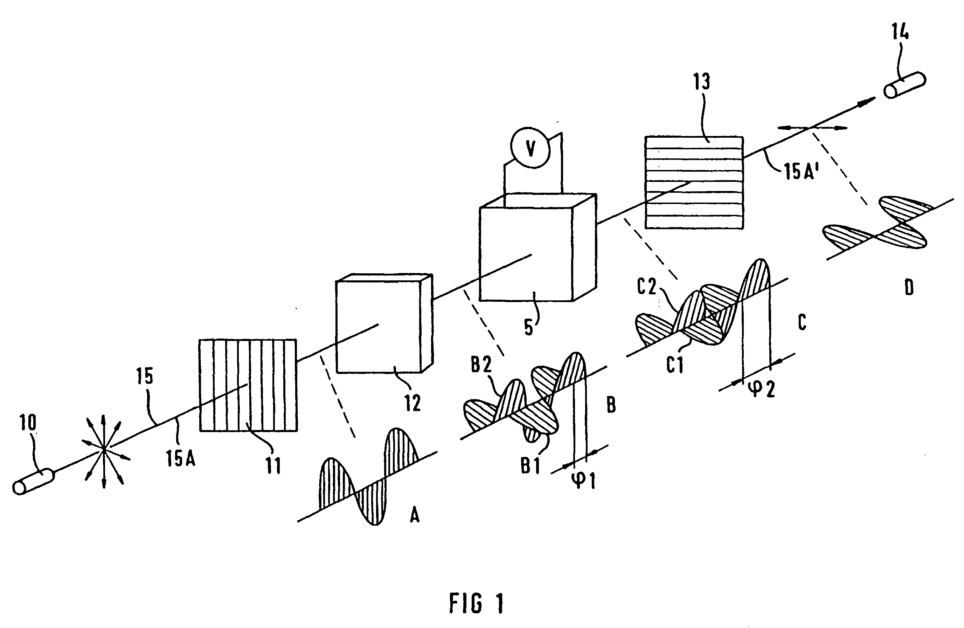

In Figur 1 ist schematisch das Prinzip einer optischen Spannungsmessung mit dem Pockels- oder Kerr-Effekt dargestellt. Entlang einer Geraden 15 sind hintereinander geschaltet eine Lichtquelle 10, ein Polarisator 11, ein λ/4-Plättchen 12, ein Sensorelement 5, ein Analysator 13 und ein Empfänger 14. Entlang der Geraden 15 tritt ein unpolarisierter Lichtstrahl 15A durch den Polarisator 11. Der jeweilige Polarisationszustand A, B, C des Lichtes 15A ist parallel zur Geraden 15 schematisch gezeigt. Beim Austritt aus dem Polarisator 11 ist das Licht 15A linear polarisiert, dargestellt als Polarisationszustand A. Das linear polarisierte Licht 15A tritt in ein λ/4-Plättchen 12 ein. Beim Austritt aus dem λ/4-Plättchen 12 ist das Licht 15A zirkular polarisiert. Dies ist als Polarisationszustand B schematisch gezeigt. Der zirkular polarisierte Zustand B ist aus zwei linear polarisierten Zuständen B1 und B2, deren jeweilige Schwingungsebene senkrecht zueinander gerichtet ist, zusammengesetzt. Das zirkular polarisierte Licht 15A durchläuft das Sensorelement 5. Wird kein äußeres elektrisches Feld über dem Sensorelement 5 angelegt, so bleibt der Polarisationszustand B des Lichtes 15A unverändert. Der nach Austritt des Lichtes 15A aus dem λ/4-Plättchen 12 vorliegende zirkular polarisierte Zustand B ist gerade dadurch charakterisiert, daß die Komponenten B1, B2 zueinander eine Phasenverschiebung ϕ1 von einem Viertel der Lichtwellenlänge λ haben. Wird nun über dem Sensorelement 5 eine Spannung V angelegt, so wird durch diese Spannung V im Sensorelement 5 ein elektrisches Feld aufgebaut. Dieses elektrische Feld ergibt je nach Art des Sensorelements 5 den Pockel's- oder Kerr-Effekt, d.h., es tritt Doppelbrechung auf. Diese führt dazu, daß sich eine von λ/4 verschiedene Phasenverschiebung ϕ2 der Komponenten C1 und C2 des nach dem Durchlauf des Sensorelements 5 auftretenden Polarisationszustandes C ergibt. Damit wird das zirkular polarisierte Licht 15A in elliptisch polarisiertes Licht 15A' verwandelt. Das Licht 15A' tritt anschließend durch den Analysator 13. Die Lichtintensität des durch den Analysator 13 gelangenden Lichtanteils des Lichtes 15A' wird im Empfänger 14 gemessen. Je nach Stellung des Analysators 13 ist gegenüber dem spannungsfreien Fall im Empfänger 14 eine höhere oder niedrigere Intensität meßbar. Über diese Intensitätsveränderung wird auf die am Sensorelement 5 wirkende Spannung V zurückgeschlossen.

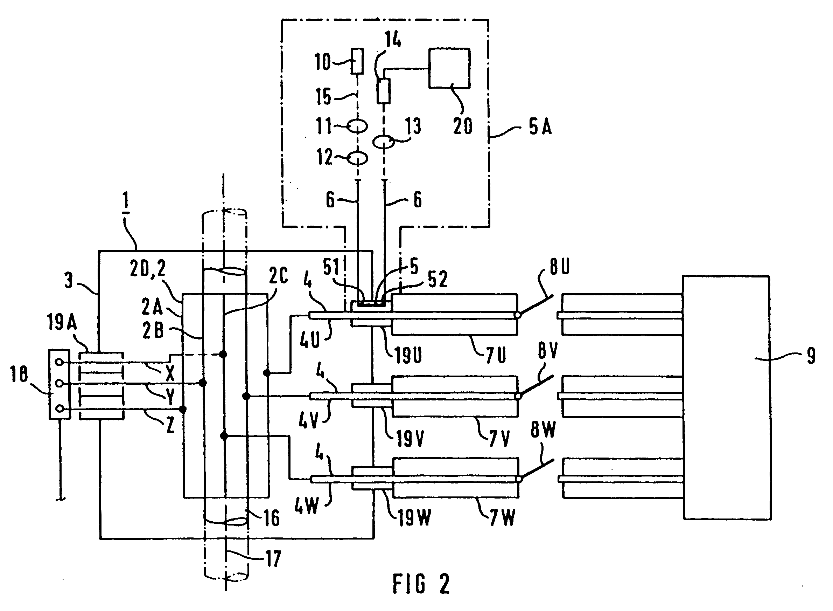

In Figur 2 ist schematisch ein Generator 1 mit einer optischen Meßvorrichtung 5a dargestellt. Der Generator 1 weist ein Generatorgehäuse 3 auf. Im Generatorgehäuse 3 ist entlang einer Achse 17 ein Rotor 16 angeordnet. Dieser wird umgeben von einer stationären elektrischen Wicklung 2 mit elektrischen Leitern 2D, die an einem nicht dargestellten Blechpaket angeordnet ist. Blechpaket und elektrische Wicklung 2 bilden den Stator. Die Wicklung 2 ist aus drei Spulen 2A, 2B und 2C, die zueinander um 120° phasenversetzte Ströme erzeugen, aufgebaut. Die elektrischen Leiter 2D der elektrischen Wicklung 2 erstrecken sich im wesentlichen entlang der Achse 17. Von jeder Spule 2A, 2B und 2C führt eine jeweilige Mittelpunktsableitung X, Y und Z. Jede dieser Mittelpunktsableitungen X, Y, Z wird mittels einer Stromdurchführung 19A aus dem Generatorgehäuse 3 herausgeführt. An einem Sternpunkt 18 werden die drei Mittelpunktsableitungen X, Y, Z zusammengeschaltet. Weiterhin führt von jeder Spule 2A, 2B, 2C eine jeweilige Ableitung 4,4U, 4,4V und 4,4W. Jede dieser Ableitungen 4U, 4V, 4W wird mit einer Stromdurchführung 19 aus dem Generatorgehäuse 3 herausgeführt. Außerhalb des Generatorgehäuses 3 schließt sich an jede Stromdurchführung 19 ein jeweiliges, jede Ableitung 4U, 4V, 4W umgebendes, Hüllrohr 7U, 7V, 7W an. Jede Ableitung 4U, 4V, 4W ist durch einen jeweiligen Schalter 8U, 8V, 8W schließbar und unterbrechbar. Von jedem Schalter 8U, 8V, 8W führt jede Ableitung 4U, 4V, 4W weiter zu einem Transformator 9. Mit dem Generator 1 ist eine Meßvorrichtung 5A verbunden, die entsprechend dem Meßprinzip aus Figur 1 aufgebaut ist: Entlang einer Geraden 15 sind eine Lichtquelle 10, ein Polarisator 11 und ein λ/4 Plättchen 12 angeordnet. Hinter dem λ/4 Plättchen 12 erstreckt sich entlang der Geraden 15 eine Glasfaser 6. Die Glasfaser 6 führt in eine der Stromdurchführungen 19. In der Stromdurchführung 19 ist parallel zur dort geführten Ableitung 4 ein Sensorelement 5 angeordnet. Dieses Sensorelement 5 ist als lichtleitende Faser mit einem ersten Ende 51 und einem zweiten Ende 52 aus einem Material ausgeführt, welches den Pockels-Effekt zeigt. Die Glasfaser 6 ist mit dem ersten Ende 51 verbunden. Eine weitere Glasfaser 6 ist mit dem zweiten Ende 52 verbunden und führt aus der Stromdurchführung heraus. Diese Glasfaser 6 führt zu einem Analysator 13. Hinter diesem ist ein Empfänger 14 angeordnet. Der Empfänger 14 ist mit einer Auswertevorrichtung 20 verbunden.

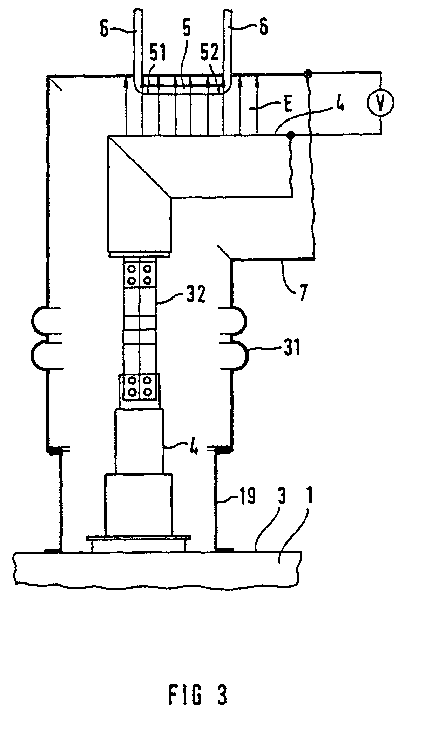

Im Betrieb eines solchen Generators 1 treibt eine nicht dargestellte Turbine den Rotor 16 an. Durch nicht dargestellte elektrische Leiter auf dem Umfang des Rotors 16 wird ein elektrischer Strom geführt. Dieser hat ein Magnetfeld zur Folge, welches in der elektrischen Wicklung 2 einen elektrischen Strom induziert. Dieser Strom wird als Drehstrom in einer Sternschaltung über die Ableitungen 4 und die Mittelpunktsableitungen X, Y und Z aus dem Generator 1 herausgeführt. Wichtige Größen zur Überwachung des Betriebszustandes des Generators 1 sind Generatorspannungen V, insbesondere an den Ableitungen 4U, 4V und 4W auftretende Generatorspannungen V, da diese die maßgeblichen, z.B. in ein Netz einzuspeisenden Spannungen liefern. Die hier auftretenden Generatorspannungen V sind sehr hoch und erfordern für ihre Messung bei konventioneller Meßtechnik, etwa bei einer induktiven Aufnahme, einen hohen apparativen Aufwand. Insbesondere führt die zu erzielende Hochspannungsfestigkeit zu einem hohen Isolierungsaufwand. Demgegenüber ist die Spannungsmessung mittels einer optischen Meßvorrichtung 5A einfacher und weniger anfällig. Für ein Sensorelement 5 verwendbare Materialien sind im allgemeinen schon für sich hochspannungsfest und erfordern keine zusätzliche Isolierung. Die Spannungsmessung erfolgt im hier gezeigten Beispiel analog zum in Figur 1 vorgestellten Meßprinzip. Eine weitere mögliche Anordnung des Sensorelementes 5 ist jeweils in den Hüllrohren 7U, 7V, 7W einer der Ableitungen 4U, 4V, 4W. Dies ist im Detail in Figur 3 dargestellt.

Figur 3 zeigt eine aus dem Generator 1 führende Ableitung 4. Die Ableitung 4 wird aus dem Generatorgehäuse 3 mittels der Stromdurchführung 19 herausgeführt. Anschließend an die Stromdurchführung 19 wird die Ableitung 4 gebildet durch elastische, stromleitende Bänder 32. An diese schließt sich ein massiver, einen rechten Winkel bildender, zylindrischer Leiter an. Die Ableitung 4 umschließend und dem rechten Winkel folgend ist ein Hüllrohr 7 angeordnet. Im Bereich der Dehnungsbänder 32 ist das Hüllrohr 7 durch geeignete Mittel 31 dehnbar ausgeführt. Diese flexible Ausführung dient, wie auch die Bänder 32, zum Ausgleich einer thermisch bedingten Längenänderung der Ableitung 4. An der Innenwand des Hüllrohrs 7 ist parallel zur Ableitung 4 ein als lichtleitende Faser mit einem ersten Ende 51 und einem zweiten Ende 52 ausgeführtes Sensorelement 5 angeordnet. Eine lichtleitende Faser 6 führt in das Hüllrohr 7 hinein und ist dort mit dem ersten Ende 51 des Sensorelementes 5 verbunden. Eine weitere lichtleitende Faser 6 ist mit dem zweiten Ende 52 des Sensorelementes 5 verbunden und führt aus dem Hüllrohr 7 heraus. Das Sensorelement 5 und die Glasfasern 6 sind wie in Fig. 2 in einer hier nicht dargestellten Meßvorrichtung 5A integriert. Zwischen dem Hüllrohr 7 und der Ableitung 4 liegt eine elektrische Spannung V, da das Hüllrohr 7 auf Erdpotential gehalten ist. Diese elektrische Spannung V hat ein elektrisches Feld E zwischen Ableitung 4 und Hüllrohr 7 zur Folge. Da Ableitung 4 und Hüllrohr 7 im Bereich des Sensorelementes 5 zueinander unverändert angeordnet sind und die gleiche Geometrie aufweisen, ist über die ganze Länge des Sensorelementes 5 das gleiche elektrische Feld E wirksam. Damit ist sichergestellt, daß über die Wirkung des elektrischen Feldes E auf das Sensorelement 5 gemäß den obigen Ausführungen zum Meßprinzip bzw. zu den optischen Effekten die Spannung V bestimmbar ist.

## Patentansprüche

1. Generator (1) mit einer elektrischen Wicklung (2) und einer, mit der elektrischen Wicklung (2) verbundenen, elektrischen Ableitung (4),
**dadurch gekennzeichnet, daß** eine optische Meßvorrichtung (5A) zur Messung einer von der elektrischen Wicklung (2) hervorrufbaren Generatorspannung (V) vorgesehen ist, umfassend:
a) ein Sensorelement (5) mit einer optischen Eigenschaft, durch welche ein auf das Sensorelement (5) einwirkendes, von der Generatorspannung hervorgerufenes elektrisches Feld (E) bestimmbar ist und
b) eine mit dem Sensorelement (5) verbundene, lichtleitfähige Faser (6).

2. Generator (1) nach Anspruch 1,
**dadurch gekennzeichnet, daß** das Sensorelement (5) ein Teil der lichtleitfähigen Faser (6) ist.

3. Generator (1) nach Anspruch 1 oder 2,
**dadurch gekennzeichnet, daß** die optische Eigenschaft eine Doppelbrechung ist, welche über den, als Pockels-Effekt bezeichneten, linearen elektrooptischen Effekt durch das elektrische Feld (E) hervorrufbar ist.

4. Generator (1) nach Anspruch 1 oder 2,
**dadurch gekennzeichnet, daß** die optische Eigenschaft eine Doppelbrechung ist, welche über den, als Kerr-Effekt bezeichneten, quadratischen elektrooptischen Effekt durch das elektrische Feld (E) hervorrufbar ist

5. Generator (1) nach Anspruch 1 oder 2,
**dadurch gekennzeichnet, daß** die optische Eigenschaft die energetische Lage oder die Aufspaltung einer Spektrallinie ist, die über den Stark-Effekt durch das elektrische Feld (E) änderbar bzw. hervorrufbar ist.

6. Generator (1) nach Anspruch 1 oder 2,
**dadurch gekennzeichnet, daß** die optische Eigenschaft eine optische Weglänge eines Lichtstrahles durch das Sensorelement (5) ist, welche über den Piezo-Effekt durch das elektrische Feld (E) änderbar ist.

7. Generator (1) nach einem der vorhergehenden Ansprüche,
**dadurch gekennzeichnet, daß** das Sensorelement (5) an der Ableitung (4) angeordnet ist.

8. Generator (1) nach Anspruch 7,
**dadurch gekennzeichnet, daß** die Ableitung (4) von einem Hüllrohr (7) umgeben ist, wobei das Sensorelement (5) an oder in diesem Hüllrohr (7) angeordnet ist.

9. Generator (1) nach einem der vorhergehenden Ansprüche,
**dadurch gekennzeichnet, daß** die Ableitung (4) einen Schalter (8) aufweist, über den ein elektrischer Strom in der Ableitung (4) ein- und abschaltbar ist, wobei das Sensorelement (5) an oder in diesem Schalter angeordnet ist.

10. Generator (1) nach einem der vorhergehenden Ansprüche,
**dadurch gekennzeichnet, daß** ein Generatorgehäuse (3) vorgesehen ist, aus dem die Ableitung (4) mittels einer Stromdurchführung (19) führt, wobei das Sensorelement (5) an oder in der Stromdurchführung (19) angeordnet ist.

11. Generator (1) nach einem der vorhergehenden Ansprüche,
**dadurch gekennzeichnet, daß** eine optische Strommeßvorrichtung vorgesehen ist, welche mit der Meßvorrichtung (5A) zu einer optischen Leistungsmessung kombinierbar ist.

12. Generator (1) nach einem der vorhergehenden Ansprüche,
**gekennzeichnet durch** eine Ausführung als Turbogenerator (1), insbesondere mit einer Leistung größer als 10 MVA.

13. Verfahren zur Messung einer Generatorspannung (V) eines Generators (1), umfassend eine elektrischen Wicklung (2) mit der eine elektrische Ableitung (4) verbunden ist,
**dadurch gekennzeichnet, daß** die Generatorspannung (V) über ein elektrisches Feld (E) auf ein Sensorelement (5) wirkt, welches Sensorelement (5) unter dieser Wirkung eine optische Eigenschaft annimmt, wobei ein Lichtstrahl (15A) über eine lichtleitende Faser (6) dem Sensorelement (5) zugeführt, ein geänderter Lichtstrahl (15A') vom Sensorelement (5) abgestrahlt und aus diesem geänderten Lichtstrahl die optische Eigenschaft des Sensorelementes (5) und daraus die Generatorspannung (V) ermittelt wird.

## Claims

1. Generator (1) having an electrical winding (2) and an electrical outgoer (4) connected to the electrical winding (2),
**characterized in that** an optical measuring device (5A) for measuring a generator voltage (V), which can be caused by the electrical winding (2), is provided, comprising:
a) a sensor element (5) having an optical property which enables an electric field (E) caused by the generator voltage and acting on the sensor element (5) to be determined, and
b) a fibre (6) having a light-guiding capability that is connected to the sensor element (5).

2. Generator (1) according to Claim 1,
**characterized in that** the sensor element (5) is part of the fibre (6) having a light-guiding capability.

3. Generator (1) according to Claim 1 or 2,
**characterized in that** the optical property is double refraction which can be caused by the electric field (E) via the linear electro-optical effect, referred to as the Pockel effect.

4. Generator (1) according to Claim 1 or 2,
**characterized in that** the optical property is double refraction which can be caused by the electric field (E) via the quadratic electro-optical effect, referred to as the Kerr effect.

5. Generator (1) according to Claim 1 or 2,
**characterized in that** the optical property is the energy position or the splitting of a spectral line which can be changed or caused by the electric field (E) via the Stark effect.

6. Generator (1) according to Claim 1 or 2,
**characterized in that** the optical property is an optical path length of a light beam through the sensor element (5) which can be changed by the electric field (E) via the piezoelectric effect.

7. Generator (1) according to one of the preceding claims,
**characterized in that** the sensor element (5) is arranged on the outgoer (4).

8. Generator (1) according to Claim 7,
**characterized in that** the outgoer (4) is surrounded by a jacket tube (7), the sensor element (5) being arranged on or in this jacket tube (7).

9. Generator (1) according to one of the preceding claims,
**characterized in that** the outgoer (4) has a switch (8), via which an electric current in the outgoer (4) can be connected and disconnected, the sensor element (5) being arranged on or in this switch.

10. Generator (1) according to one of the preceding claims,
**characterized in that** a generator housing (3) is provided from which the outgoer (4) leads by means of a current bushing (19), the sensor element (5) being arranged on or in the current bushing (19).

11. Generator (1) according to one of the preceding claims,
**characterized in that** an optical current measuring device is provided which can be combined with the measuring device (5A) to form an optical power measurement.

12. Generator (1) according to one of the preceding claims,
**characterized by** a design as a turbo-generator (1), in particular with a power output greater than 10 MVA.

13. Method for measuring a generator voltage (V) of a generator (1), comprising an electrical winding (2) to which an electrical outgoer (4) is connected,
**characterized in that** the generator voltage (V) acts via an electric field (E) on a sensor element (5), which sensor element (5) assumes an optical property under this action, a light beam (15A) being fed via a light-guiding fibre (6) to the sensor element (5), an altered light beam (15A') being radiated from the sensor element (5), the optical property of the sensor element (5) being determined from this altered light beam and the generator voltage (V) being determined from the said optical property.

## Revendications

1. Génératrice (1) comprenant un enroulement (2) électrique et une ligne (4) électrique de sortie reliée à l'enroulement (2) électrique,
**caractérisée en ce qu'**il est prévu un dispositif (5A) optique de mesure d'une tension (V) de génératrice qui peut être appelée par l'enroulement (2) électrique, comprenant :
a) un élément (5) capteur ayant une propriété optique par laquelle un champ (E) électrique agissant sur l'élément (5) capteur et provoqué par la tension de la génératrice peut être déterminé, et
b) une fibre (6) apte à conduire la lumière qui est reliée à l'élément (5) capteur.

2. Génératrice (1) suivant la revendication 1,
**caractérisée en ce que** l'élément (5) capteur fait partie de la fibre (6) apte à conduire de la lumière.

3. Génératrice (1) suivant la revendication 1 ou 2,
**caractérisée en ce que** la propriété optique est une double réfraction qui peut être provoquée par le champ (E) électrique par l'intermédiaire de l'effet linéaire électro-optique désigné comme étant l'effet Pockels.

4. Génératrice (1) suivant la revendication 1 ou 2,
**caractérisée en ce que** la propriété optique est une double réfraction qui peut être provoquée par le champ (E) électrique par l'intermédiaire de l'effet quadratique électro-optique désigné comme étant l'effet Kerr.

5. Génératrice (1) suivant la revendication 1 ou 2,
**caractérisée en ce que** la propriété optique est l'énergie ou le dédoublement d'une raie spectrale, qui peut être modifiée ou provoquée par l'intermédiaire de l'effet Stark par le champ (E) électrique.

6. Génératrice (1) suivant la revendication 1 ou 2,
**caractérisée en ce que** la propriété optique est un trajet optique d'un faisceau lumineux passant dans l'élément (5) capteur, qui peut être modifié par l'intermédiaire de l'effet piézo-électrique par le champ (E) électrique.

7. Génératrice (1) suivant l'une des revendications précédentes, **caractérisée en ce que** l'élément (5) capteur est monté sur la ligne (4) de sortie.

8. Génératrice (1) suivant la revendication 7, **caractérisée en ce que** la ligne (4) de sortie est entourée d'un tube (7) formant enveloppe, l'élément (5) capteur étant monté sur ou dans cet élément (7) formant enveloppe.

9. Génératrice (1) suivant l'une des revendications précédentes, **caractérisée en ce que** la ligne (4) de sortie comporte un interrupteur (8) par lequel un courant électrique peut passer dans is ligne (4) de sortie ou peut y être interrompu, l'élément (5) capteur étant monté sur cet interrupteur ou dans cet interrupteur.

10. Génératrice (1) suivant l'une des revendications précédentes, **caractérisée en ce qu'**il est prévu une carcasse (3) de génératrice de laquelle la ligne (4) de sortie sort au moyen d'une traversée (19), l'élément (5) capteur étant monté sur ou dans la traversée (19).

11. Génératrice (1) suivant l'une des revendications précédentes, **caractérisée en ce qu'**il est prévu un dispositif optique de mesure du courant électrique, qui peut être combiné au dispositif (5A) de mesure d'une puissance optique.

12. Génératrice (1) suivant l'une des revendications précédentes, **caractérisé par** une réalisation en turbo alternateur (1) ayant notamment une puissance supérieure à 10 MVA.

13. Procédé de mesure d'une tension (V) d'une génératrice (1) comprenant un enroulement (2) électrique auquel est reliée une ligne (4) électrique de sortie, **caractérisé en ce que** la tension (V) de la génératrice agit par l'intermédiaire d'un champ (E) électrique sur un élément (5) capteur, lequel prend sous cet effet une propriété optique, un faisceau (15A) lumineux étant envoyé à l'élément (5) capteur par une fibre (6) conductrice de la lumière, un faisceau (15A') lumineux modifié étant émis par l'élément (5) capteur et la propriété optique de l'élément (5) capteur et à partir de celle-ci la tension (V) de la génératrice étant déterminées à partir du faisceau lumineux modifié.
